# FASCICULE DE BREVET EUROPEEN

(11) **EP 1 889 527 B1**
(45) Date de publication et mention de la délivrance du brevet: **01.12.2010**
(21) Numéro de dépôt: 06764742.0
(22) Date de dépôt: 06.06.2006
(51) Int. Cl.: H05K 7/20

(54) **SYSTEME DE VENTILATION**
BELÜFTUNGSSYSTEM
VENTILATION SYSTEM

(30) Priorité: 06.06.2005 FR 0505745
(43) Date de publication de la demande: 20.02.2008
(73) Titulaire: FRANCE TELECOM, 75015 Paris (FR)
(72) Inventeur: NORTERSHAUSER David, France Télécom R & D/PIV/PI, F-92794 Issy- Moulineaux Cedex 9 (FR); LE MASSON Stéphane, France Télécom R & D/PIV/PI, F-92794 Issy- Moulineaux Cedex 9 (FR); GAUTIER, Jacky, France Télécom R & D/PIV/PI, F-92794 Issy- Moulineaux Cedex 9 (FR)
(74) Mandataire: Guy, Marion
(86) Numéro de dépôt international: PCT/FR2006/001282
(87) Numéro de publication internationale: WO 2006/131642

(56) Documents cités:
- DE-U1-202004 006 552
- US-A- 4 742 864
- PATENT ABSTRACTS OF JAPAN vol. 2003, no. 11, 5 novembre 2003 (2003-11-05) & JP 2003 193577 A (MAX CO LTD), 9 juillet 2003 (2003-07-09)

## Description

L'invention concerne un système de ventilation ainsi qu'un local équipé d'un tel système de ventilation.

Elle trouve application dans le domaine de l'évacuation de la chaleur et, en particulier, pour évacuer la chaleur de locaux techniques dans lesquels sont disposés des équipements dissipant de la chaleur.

Les équipements dissipateurs de chaleur, par exemple les équipements de télécommunications (centraux, etc.) sont de plus en plus souvent placés à l'extérieur des bâtiments existants dans des locaux techniques du type armoire de trottoir, chambre souterraine, etc. Ces locaux techniques sont alors soumis à un environnement climatique sévère en raison de l'action conjuguée du flux solaire, de la température extérieure et de la chaleur dissipée par les équipements. Pour garantir le bon fonctionnement des équipements disposés dans les locaux techniques, il faut que la température intérieure de ces locaux reste inférieure à une valeur maximale.

Pour garantir le maintien de la température intérieure des locaux, il est possible de disposer un système de ventilation interne, du type comprenant un dispositif d'entraînement d'air, mais celui-ci ne fait que du brassage de l'air ambiant et il est totalement inefficace du fait qu'aucun échange énergétique avec l'air extérieur n'a lieu. Pour résoudre ce problème, il est alors possible de mettre en place une ouverture vers l'extérieur qui permet l'introduction d'air extérieur plus frais que l'air contenu dans les locaux, mais dans ce cas, cette introduction peut se combiner avec une introduction d'eau qui peut inonder le local technique et en particulier nuire au bon fonctionnement du dispositif d'entraînement d'air si celui-ci entre en contact avec l'eau.

DE202004006552U U1 montre un local avec un système de refroidissement comprenant une canalisation étanche, un orifice d'admission d'air au dessus de la canalisation avec un dispositif d'entraînement d'air, un orifice d'évacuation d'air en bas de la canalisation, et un échangeur de chaleur de l'eau.

JP2003193577 décrit un système de ventilation d'air destine a être monté sur un support comprenant un orifice d'admission d'air, un orifice d'évacuation d'air, une canalisation reliant ces deux orifices et un dispositif d'entrainement d'air agencé dans une portion de la canalisation. L'orifice d'admission d'air est relié a l'extérieur du local et l'orifice d'évacuation d'air rejette l'air dans le local a ventiler.

Un objet de la présente invention est de proposer un système de ventilation qui ne présente pas les inconvénients de l'art antérieur et qui permette de réaliser un échange énergétique avec l'air extérieur tout en préservant le dispositif d'entraînement d'air de l'eau pouvant pénétrer à l'intérieur du local technique.

A cet effet, est proposé un système de ventilation, destiné à être monté sur un support comprenant une base, le système de ventilation comprenant:
- un orifice d'admission d'air;
- un orifice d'évacuation d'air;
- une canalisation étanche reliant l'orifice d'admission d'air à l'orifice d'évacuation d'air;
- un dispositif d'entraînement d'air disposé à l'intérieur d'une portion de ladite canalisation.

Le système de ventilation est tel que, lorsqu'il est en position de montage sur le support, ladite portion est située à une hauteur, par rapport à la base, supérieure à celle dudit orifice d'admission d'air et à celle dudit orifice d'évacuation d'air. Cette mise en hauteur du dispositif d'entraînement d'air évite que ce dernier soit inondé par une montée des eaux dans la canalisation.

Selon un mode de réalisation particulier, la canalisation a la forme d'un U dont l'une des branches est reliée à l'orifice d'admission d'air par une première conduite de liaison et dont l'autre branche est reliée à l'orifice d'évacuation d'air par une deuxième conduite de liaison, et, lorsque le système de ventilation est en position de montage, la première conduite de liaison et la deuxième conduite de liaison sont sensiblement horizontales, par rapport à la base.

Selon un mode de réalisation particulier, lorsque le système de ventilation est en position de montage, l'orifice d'admission d'air et l'orifice d'évacuation d'air sont situés sensiblement à la même hauteur, par rapport à la base.

Avantageusement, ladite portion est munie d'un dispositif anti-capillarité au niveau du dispositif d'entraînement d'air.

Avantageusement, au moins un thermostat est disposé à l'intérieur de la canalisation.

Avantageusement, au moins un détecteur de présence d'eau est disposé à l'intérieur de la-canalisation.

L'invention propose aussi un local comprenant:
- un ensemble de parois dont au moins une est une base
- un moyen d'entrée d'air disposé sur l'une des parois;
- un moyen de sortie d'air disposé sur l'une des parois; et
- un système de ventilation selon l'un des objets précédents, monté sur une paroi servant de support et dont l'air contenu dans ledit local est capté par l'orifice d'admission d'air puis canalisé de l'orifice d'évacuation d'air vers ledit moyen de sortie d'air.

Selon un mode de réalisation particulier, une conduite intermédiaire est disposée entre l'orifice d'évacuation d'air et ledit moyen de sortie d'air.

Selon un mode de réalisation particulier, la conduite intermédiaire est distante de l'orifice d'évacuation d'air et/ou dudit moyen de sortie d'air.

Selon un mode de réalisation particulier, l'orifice d'admission d'air et le moyen d'entrée d'air sont disposés de manière à ce que l'air qui pénètre par le moyen d'entrée d'air traverse la majorité du volume dudit local.

Selon un mode de réalisation particulier, la portion de la canalisation contenant le dispositif d'entraînement d'air est disposée à l'intérieur dudit local.

Selon un mode de réalisation particulier, la portion de la canalisation contenant le dispositif d'entraînement d'air est disposée à l'extérieur dudit local.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels:
la Fig. 1 représente une vue en perspective d'un local technique comprenant un système de ventilation selon l'invention;
la Fig. 2 représente une vue de côté du local de la Fig. 1 du côté de l'admission d'air;
la Fig. 3 représente une vue de côté du local de la Fig. 1 du côté de l'évacuation d'air selon un mode de réalisation de l'invention;
la Fig. 4 représente une vue de côté du local de la Fig. 1 du côté de l'évacuation d'air selon un autre mode de réalisation de l'invention;
la Fig. 5 représente une vue de côté du local de la Fig. 1 du côté de l'évacuation d'air selon un autre mode de réalisation de l'invention;
la Fig. 6 représente une vue de côté du local de la Fig. 1 du côté de l'évacuation d'air selon un autre mode de réalisation de l'invention; et
les Figs. 7a, 7b, 7c représentent des dispositifs anti-capillarité.

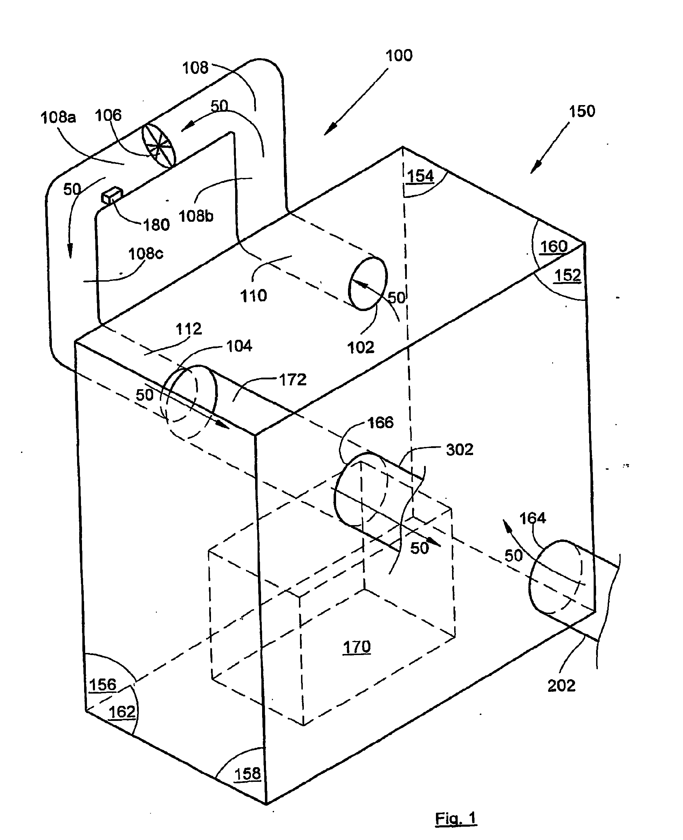

la Fig. 1 représente un local technique 150 comprenant un système de ventilation 100 selon l'invention.

Le local technique 150 est constitué d'un ensemble de parois 152,154,156,158, 160 et 162 délimitant un volume intérieur dans lequel sont disposés des équipements 170, par exemple électroniques, qui dissipent de la chaleur devant être évacuée vers l'extérieur. Les équipements 170 sont généralement enfermés dans une enceinte étanche.

Selon ce mode de réalisation, une des parois fait office de base au local 150, la paroi 162. La paroi 156, sensiblement verticale par rapport à la base 162, est destinée à accueillir un système de ventilation 100 en position de montage. La paroi 156 sert alors de support pour le montage du système de ventilation 100.

Pour des facilités de compréhension, la paroi supérieure 160 du local 150 n'a pas été représentée sur la Fig. 1 et seule sa référence apparaît.

Le local technique 150 comprend:
- un moyen d'entrée d'air 164 disposé sur l'une des parois 152;
- un moyen de sortie d'air 166 disposé sur l'une des parois 152; et
- un système de ventilation 100 qui génère un mouvement d'air représenté par les flèches 50.

Le système de ventilation est monté sur la paroi 156 servant de support.

Selon un mode de réalisation particulier, les moyens d'entrée et de sortie d'air comprennent respectivement un orifice d'admission et un orifice d'évacuation.

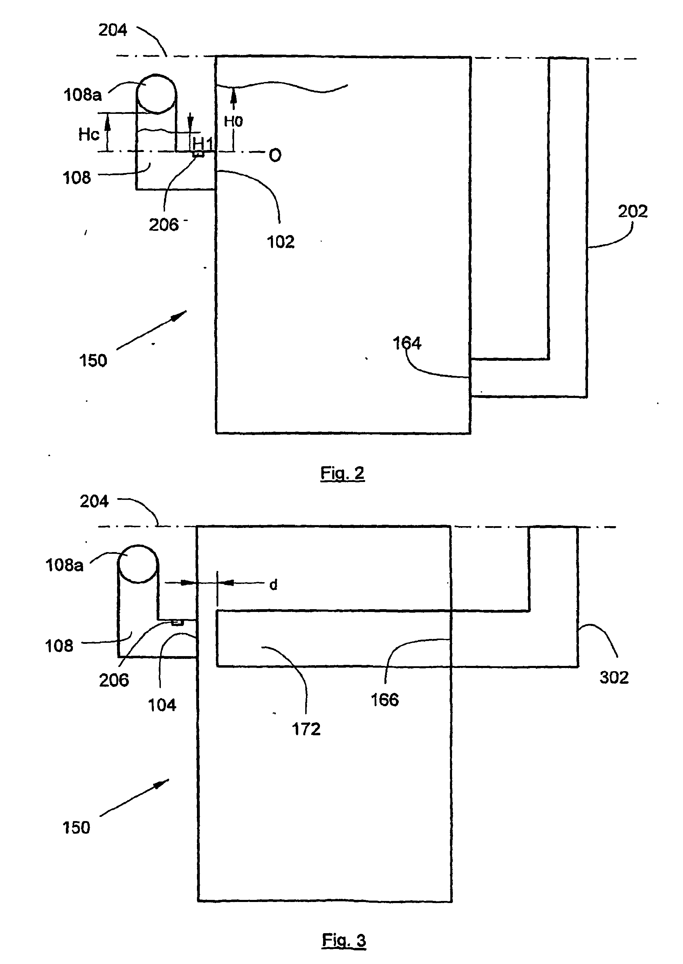

Comme cela est représenté sur les Figs. 2 à 5, le local 150 est de préférence enterré sous le niveau du sol représenté par la référence 204.

Comme cela est représenté sur la Fig. 2, le moyen d'entrée d'air 164 est relié à l'extérieur par une conduite d'admission d'air 202 qui débouche au niveau du sol 204. Le moyen de sortie d'air 166 est relié à l'extérieur par une conduite d'évacuation 302 qui débouche au niveau du sol 204.

Le moyen d'entrée d'air 164 permet à l'air extérieur au local 150 de rentrer dans le local 150. L'air extérieur est plus frais que l'air contenu dans le local 150. Le moyen de sortie d'air 166 permet à l'air intérieur au local 150 de sortir du local 150 vers l'extérieur, permettant ainsi d'évacuer des calories puisque l'air évacué est plus chaud que l'air entrant.

Le système de ventilation 100 comprend:
- un orifice d'admission d'air 102;
- un orifice d'évacuation d'air 104;
- une canalisation 108 étanche reliant l'orifice d'admission d'air 102 à l'orifice d'évacuation d'air 104; et
- un dispositif d'entraînement d'air 106 disposé à l'intérieur d'une portion 108a de la canalisation 108.

L'air frais venant de l'extérieur pénètre ainsi dans le local 150 par la conduite d'admission d'air 202, puis l'air ainsi introduit se chauffe au contact de l'air contenu dans le local 150 et des équipements 170 avant d'être capté par l'orifice d'admission d'air 102 qui est adapté à le capter. L'air ainsi capté est ensuite expulsé par l'orifice d'évacuation d'air 104 et canalisé de l'orifice d'évacuation d'air 104 vers le moyen de sortie d'air 166 puis vers l'extérieur par la conduite d'évacuation 302. Le dispositif d'entraînement d'air 106 permet ainsi de générer un mouvement d'air à l'intérieur du local technique et l'air contenu dans le local technique 150 peut ainsi avoir un échange énergétique important avec l'air extérieur, ce qui permet le maintien de la température intérieure du local 150 sous la température maximale de fonctionnement.

Le dispositif d'entraînement d'air 106 qui peut être du type ventilateur motorisé doit être maintenu dans un environnement sec et en particulier, dans le cas où de l'eau pénètre dans le local technique 150, par exemple lors de pluie, le dispositif d'entraînement d'air 106 ne doit pas être submergé par cette eau.

Pour éviter tout contact entre le dispositif d'entraînement d'air 106 et l'eau lorsque le système de ventilation 100 est en position de montage, la portion 108a de la canalisation 108 contenant le dispositif d'entraînement d'air 106 est située à une hauteur, par rapport à la base, supérieure à celle de l'orifice d'admission d'air 102 et à celle de l'orifice d'évacuation d'air 104. Ainsi, lorsque de l'eau pénètre par l'orifice d'admission d'air 102 et l'orifice d'évacuation d'air 104, l'étanchéité de la canalisation 108 et la position de la portion 108a contenant le dispositif d'entraînement d'air 106 font que l'eau ne peut pas monter puisque l'air contenu dans la portion 108a est mis sous pression par l'eau et que cette pression empêche l'eau de monter jusqu'au dispositif d'entraînement d'air 106 qui reste ainsi hors de l'eau.

Sur la Fig. 2 est représenté un local 150 inondé. Dans l'exemple de réalisation de l'invention, les-différentes hauteurs qui seront explicitées ci-après ont pour référence O, le haut de l'orifice d'admission d'air 102. H_{c} représente la hauteur à partir de laquelle le dispositif d'entraînement d'air 106 est inondé, H₀ représente la hauteur à laquelle l'eau est montée dans le local 150 et H₁ représente la hauteur à laquelle l'eau est montée dans la canalisation 108. On note aussi P_{c} la pression de l'air dans la canalisation 108 et Pₑ la pression exercée par l'eau dans la canalisation 108.

Pour que le dispositif d'entraînement d'air 106 ne soit pas inondé, il faut que H₁<H_{c}.

Dans le mode particulier de l'invention et pour un ventilateur conventionnel, la hauteur H_{c} est de l'ordre de 10 cm.

Le système de ventilation 100 permet ainsi de maintenir la température de l'air contenu dans le local 150 à une valeur inférieure à la température de fonctionnement maximale tout en préservant le dispositif d'entraînement d'air 106 à l'abri de l'eau. Le fonctionnement du dispositif d'entraînement d'air 106 et, en particulier sa vitesse, peut être commandé par des thermostats répartis dans le local. Un ou des thermostats 180 peuvent être aussi disposés dans la canalisation 108, ce qui permet de moduler la vitesse de l'air par modification de la vitesse du dispositif d'entraînement d'air 106 selon la température atteinte à l'intérieur de cette canalisation 108.

Dans un mode particulier de l'invention, la canalisation 108 a la forme d'un U dont l'une des branches 108b est reliée à l'orifice d'admission d'air 102 par une première conduite de liaison 110 et dont l'autre branche 108c est reliée à l'orifice d'évacuation d'air 104 par une deuxième conduite de liaison 112, et où, lorsque le système de ventilation 100 est en position de montage, la première conduite de liaison 110 et la deuxième conduite de liaison 112 sont sensiblement horizontales par rapport à la paroi 162 servant de base. La canalisation 108 est ainsi formée de quatre coudes à 90° et de tuyaux droits.

Lorsque le système de ventilation 100 est en position de montage, l'orifice d'admission d'air 102 et l'orifice d'évacuation d'air 104 sont situés sensiblement à la même hauteur par rapport à la base, permettant ainsi que l'eau monte de manière symétrique dans la canalisation 108 de part et d'autre du dispositif d'entraînement d'air 106.

La Fig. 2 représente une vue de côté du local 150 du côté de l'admission d'air, c'est-à-dire du côté du moyen d'entrée d'air 164 et de l'orifice d'admission d'air 102. Pour que l'air frais de l'extérieur pénétrant par le moyen d'entrée d'air 164 puisse refroidir l'air contenu dans le local 150, l'orifice d'admission d'air 102 et le moyen 'd'entrée d'air 164 sont disposés de manière à ce que l'air qui pénètre par le moyen d'entrée d'air 164 traverse la majorité du volume du local 150. Dans l'exemple de la Fig. 2, le moyen d'entrée d'air 164 est disposé à la base du local 150 tandis quc l'orifice d'admission d'air 102 est disposé sensiblement au sommet du local 150. Bien entendu, cette disposition peut être modifiée selon le volume du local 150 et l'emplacement des équipements 170. Le moyen d'entrée d'air 164 et l'orifice d'admission d'air 102 doivent être choisis de manière à ce que l'air frais vienne circuler autour des équipements 170 et ainsi les refroidir grâce aux hautes vitesses d'air imposées.

Les Figs. 3 à 5 représentent des vues de côté du local 150 du côté de l'évacuation d'air, c'est-à-dire du côté de l'orifice d'évacuation d'air 104 et du moyen de sortie d'air 166 selon différents modes de réalisation de l'invention.

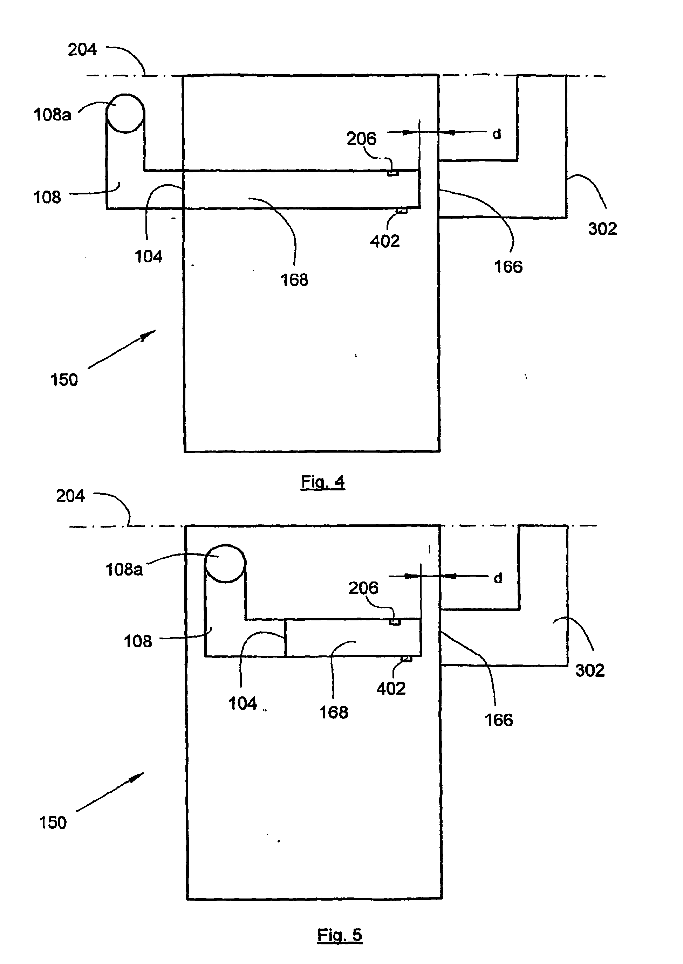

Les Figs. 3 et 4 présentent des modes dans lesquels le système de ventilation 100 et, en particulier, la portion de la canalisation contenant le dispositif d'entraînement d'air 106 sont disposés à l'extérieur du local 150.

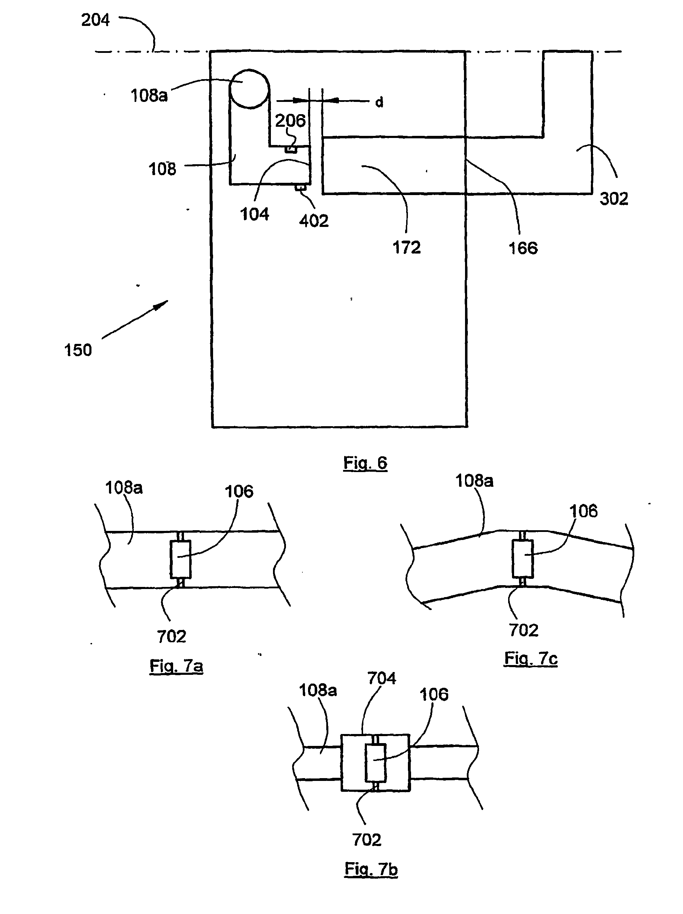

Les Figs. 5 et 6 présentent des modes dans lesquels le système de ventilation 100 et, en particulier, la portion de la canalisation contenant le dispositif d'entraînement d'air 106 sont disposés à l'intérieur du local 150. Dans ces modes de réalisations particuliers, le système de ventilation 100 est fixé à la paroi 156 servant de support par l'intermédiaire de moyens d'accrochage non représentés.

Ces modes de réalisation sont équivalents et peuvent être choisis en fonction de l'espace disponible à l'intérieur ou à l'extérieur du local 150. C'est-à-dire que si le volume disponible à l'intérieur du local 150 est limité, le système de ventilation 100 sera de préférence disposé à l'extérieur du local 150. Si le volume disponible pour placer le local 150 est limité, par exemple à cause de constructions environnantes, le système de ventilation 100 sera de préférence disposé à l'intérieur du local 150.

Pour canaliser l'air chaud qui est expulsé par l'orifice d'évacuation d'air 104 et le canaliser vers le moyen de sortie d'air 166, une conduite intermédiaire 168, 172 est disposée entre l'orifice d'évacuation d'air 104 et le moyen de sortie d'air 166.

Dans le mode de réalisation de l'invention représenté à la Fig. 3, la conduite intermédiaire 172 est solidaire de la conduite d'évacuation 302 et est distante d'une distance d de l'orifice d'évacuation d'air 104. Cet espace (d) ainsi créé, évite que de l'eau pénétrant dans la conduite d'évacuation 302 remonte jusqu'au dispositif d'entraînement d'air 106, puisque l'eau coule dans le local 150. Pour que l'air passe aisément de l'orifice d'évacuation d'air 104 dans la conduite intermédiaire 172, cette dernière possède une ouverture disposée en vis-à-vis de l'orifice d'évacuation d'air 104 dont le diamètre est supérieur à celui de l'orifice d'évacuation d'air 104.

Dans le mode de réalisation de l'invention représenté à la Fig. 4, la conduite intermédiaire 168 est solidaire de la canalisation 108 et est distante d'une distance d du moyen de sortie d'air 166. Cet espace (d) ainsi créé évite que de l'eau pénétrant dans la conduite d'évacuation 302 remonte jusqu'au dispositif d'entraînement d'air 106, puisque l'eau coule dans le local 150. Pour que l'air passe aisément de la conduite intermédiaire 168 dans le moyen de sortie d'air 166, ce dernier à un diamètre supérieur à celui de l'ouverture de la conduite intermédiaire 168.

Dans le mode de réalisation de l'invention représenté à la Fig. 5, la conduite intermédiaire 168 est solidaire de la canalisation 108 et est distante d'une distance d du moyen de sortie d'air 166. Cet espace (d) ainsi créé évite que de l'eau pénétrant dans la conduite d'évacuation 302 remonte jusqu'au dispositif d'entraînement d'air 106, puisque l'eau coule dans le local 150. Pour que l'air passe aisément de la conduite intermédiaire 168 dans le moyen de sortie d'air 166, ce dernier à un diamètre supérieur à celui de l'ouverture de la conduite intermédiaire 168.

Dans le mode de réalisation de l'invention représenté à la Fig. 6, la conduite intermédiaire 172 est solidaire de la conduite d'évacuation 302 et est distante d'une distance d de l'orifice d'évacuation d'air 104. Cet espace (d) ainsi créé évite que de l'eau pénétrant dans la conduite d'évacuation 302 remonte jusqu'au dispositif d'entraînement d'air 106, puisque l'eau coule dans le local 150. Pour que l'air passe aisément de l'orifice d'évacuation d'air 104 dans la conduite intermédiaire 172, cette dernière possède une ouverture disposée en vis-à-vis de l'orifice d'évacuation d'air 104 dont le diamètre est supérieur à celui de l'orifice d'évacuation d'air 104.

La distance d est de l'ordre de 5 à 10 cm.

L'orifice d'admission d'air 102 et l'orifice d'évacuation d'air 104 sont de préférence disposés en haut du local 150 pour fonctionner le plus longtemps possible même lorsque le local 150 est inondé.

Pour éviter que le dispositif d'entraînement d'air 106 continue de fonctionner lorsque la canalisation 108 est remplie d'eau, des détecteurs de présence d'eau peuvent être disposés à-l'intérieur de la canalisation 108. Ces détecteurs informent le dispositif d'entraînement d'air 106 que l'eau remplit la canalisation 108 et que, par conséquent, il doit s'arrêter de fonctionner. Sur les Figs. 2 à 6 a été représenté un détecteur de présence d'eau 206 disposé sur la partie supérieure de la première conduite de liaison 110. Ce détecteur de présence d'eau 206 permet, en cas de détection d'eau, d'informer le dispositif d'entraînement d'air 106 qui s'arrête. Il est préférable de disposer un tel détecteur de présence d'eau dans la première conduite de liaison 110 et dans la deuxième conduite de liaison 112.

Pour obtenir une information sur la montée du niveau d'eau, un ou des détecteurs de présence d'eau 402 (Figs. 4, 5 et 6) peuvent être disposés sous les entrées des canalisations. Ces détecteurs de présence d'eau 402 permettent d'informer de l'imminence de l'entrée d'eau dans la canalisation 108.

Dans le cas où de l'eau remonterait par capillarité le long de la canalisation 108 en direction du dispositif d'entraînement d'air 106, il est préférable de disposer des dispositifs anti-capillarité évitant ces remontées au niveau du dispositif d'entraînement d'air 106.

Les Figs. 7a, 7b et 7c représentent de tels dispositifs anti-capillarité.

Dans le cas de la Fig. 7a, la portion 108a de la canalisation 108 dans laquelle est disposé le dispositif d'entraînement d'air 106 a un diamètre supérieur aux dimensions dudit dispositif d'entraînement d'air 106 qui est maintenu dans la canalisation 108 à l'aide d'entretoises 702.

Dans le cas de la Fig. 7b, le même effet est obtenu, bien que le diamètre de la canalisation 108 soit inférieur aux dimensions dudit dispositif d'entraînement d'air 106, par l'ajout d'un boîtier 704 dont les dimensions sont supérieures aux dimensions du dispositif d'entraînement d'air 106.

Dans le cas de la Fig. 7c, le même effet est obtenu par le fait que la canalisation 108 n'est pas horizontale mais qu'elle monte en direction du dispositif d'entraînement d'air 106 en amont et en aval de celui-ci.

Bien entendu, la présente invention n'est pas limitée aux exemples et modes de réalisation décrits et représentés ici, mais elle est susceptible de nombreuses variantes accessibles à l'homme de l'art.

## Revendications

1. Système de ventilation (100) d'un local, destiné à être monté sur un support (156) comprenant une base (162), le système de ventilation (100) comprenant:
- un orifice d'admission d'air (102)
- un orifice d'évacuation d'air (104);
- une canalisation (108) étanche reliant l'orifice d'admission d'air (102) à l'orifice d'évacuation d'air (104);
- un dispositif d'entraînement d'air (106) disposé à l'intérieur d'une portion (108a) de ladite canalisation (108),
le système de ventilation (100) étant **caractérisé en ce que** ledit orifice d'admission d'air (102) est adapté pour capter l'air du local à ventiler;
et **en ce que** lorsque le système de ventilation est en position de montage, ladite portion (108a) est située à une hauteur, par rapport à la base, supérieure à celle dudit orifice d'admission d'air (102) et à celle dudit orifice d'évacuation d'air (104).

2. Système de ventilation (100) selon la revendication 1, **caractérisé en ce que** la canalisation (108) a la forme d'un U dont l'une des branches (108b) est reliée à l'orifice d'admission d'air (102) par une première conduite de liaison (110) et dont l'autre branche (108c) est reliée à l'orifice d'évacuation d'air (104) par une deuxième conduite de liaison (112), et **en ce que**, lorsque le système de ventilation (100) est en position de montage, la première conduite de liaison (110) et la deuxième conduite de liaison (112) sont sensiblement horizontales, par rapport à la base.

3. Système de ventilation (100) selon l'une des revendications 1 à 2, **caractérisé en ce que**, lorsque le système de ventilation (100) est en position de montage, l'orifice d'admission d'air (102) et l'orifice d'évacuation d'air (104) sont situés sensiblement à la même hauteur, par rapport à la base.

4. Système de ventilation (100) selon l'une des revendications 1 à 3, **caractérisé en ce que** ladite portion (108a) est munie d'un dispositif anti-capillarité au niveau du dispositif d'entraînement d'air (106).

5. Système de ventilation (100) selon l'une des revendications 1 à 4, **caractérisé en ce qu'**au moins un thermostat (180) est disposé à l'intérieur de la canalisation (108).

6. Système de ventilation (100) selon l'une des revendications 1 à 5, **caractérisé en ce qu'**au moins un détecteur de présence d'eau (206) est disposé à l'intérieur de la canalisation (108).

7. Local (150) comprenant: - un ensemble de parois (152-162) dont au moins une est une base (162), - un moyen d'entrée d'air (164) disposé sur l'une des parois (152); - un moyen de sortie d'air (166) disposé sur l'une des parois (152); le local étant **caractérisé en ce qu'**il comprend en outre un système de ventilation (100) selon l'une des revendications 1 à 6, monté sur une paroi (156) servant de support et dont l'air contenu dans ledit local (150) est capté par l'orifice d'admission d'air (102) puis canalisé de l'orifice d'évacuation d'air (104) vers le moyen de sortie d'air (166).

8. Local (150) selon la revendication 7, **caractérisé en ce qu'**une conduite intermédiaire (168, 172) est disposée entre l'orifice d'évacuation d'air (104) et le moyen de sortie d'air (166).

9. Local (150) selon la revendication 8, **caractérisé en ce que** la conduite intermédiaire (168, 172) est distante (d) de l'orifice d'évacuation d'air (104) et/ou du moyen de sortie d'air (166).

10. Local (150) selon l'une des revendications 7 à 9, **caractérisé en ce que** l'orifice d'admission d'air (102) et le moyen d'entrée d'air (164) sont disposés de manière à ce que l'air qui pénètre par le moyen d'entrée d'air (164) traverse la majorité du volume dudit local (150).

11. Local (150) selon l'une des revendications 7 à 10, **caractérisé en ce que** la portion (108a) de la canalisation (108) contenant le dispositif d'entraînement d'air (106) est disposée à l'intérieur dudit local (150).

12. Local (150) selon l'une des revendications 7 à 10, **caractérisé en ce que** la portion (108a) de la canalisation (108) contenant le dispositif d'entraînement d'air (106) est disposée à l'extérieur dudit local (150).

## Claims

1. System (100) for ventilating a premises, designed to be mounted on a support (156) comprising a base (162), the ventilation system (100) comprising:
- an air inlet orifice (102),
- an air discharge orifice (104);
- a sealed pipe (108) connecting the air inlet orifice (102) to the air discharge orifice (104);
- a device (106) for carrying air along placed inside a portion (108a) of said pipe (108),
the ventilation system (100) being **characterized in that** said air inlet orifice (102) is suitable for capturing the air of the premises to be ventilated;
and **in that**, when the ventilation system is in the mounted position, said portion (108a) is situated at a greater height, relative to the base, than that of said air inlet orifice (102) and than that of said air discharge orifice (104).

2. Ventilation system (100) according to Claim 1, **characterized in that** the pipe (108) is U-shaped and one of its branches (108b) is connected to the air inlet orifice (102) by a first connecting duct (110) and its other branch (108c) is connected to the air discharge orifice (104) by a second connecting duct (112) and **in that**, when the ventilation system (100) is in the mounted position, the first connecting duct (110) and the second connecting duct (112) are substantially horizontal relative to the base.

3. Ventilation system (100) according to one of Claims 1 and 2, **characterized in that**, when the ventilation system (100) is in the mounted position, the air inlet orifice (102) and the air discharge orifice (104) are situated substantially at the same height relative to the base.

4. Ventilation system (100) according to one of Claims 1 to 3, **characterized in that** said portion (108a) is furnished with an anti-capillarity device at the level of the device (106) for carrying air along.

5. Ventilation system (100) according to one of Claims 1 to 4, **characterized in that** at least one thermostat (108) is placed inside the pipe (108).

6. Ventilation system (100) according to one of Claims 1 to 5, **characterized in that** at least one water-presence detector (206) is placed inside the pipe (108).

7. Premises (150) comprising: - a set of walls (152- 162) at least one of which is a base (162), - an air inlet means (164) placed on one of the walls (152); - an air outlet means (166) placed on one of the walls (152); the premises being **characterized in that** it also comprises a ventilation system (100) according to one of Claims 1 to 6, mounted on a wall (156) serving as support and in which the air contained in said premises (150) is captured by the air inlet orifice (102) and then channelled from the air discharge orifice (104) to the air outlet means (166).

8. Premises (150) according to Claim 7, **characterized in that** an intermediate duct (168, 172) is placed between the air discharge orifice (104) and the air outlet means (166).

9. Premises (150) according to Claim 8, **characterized in that** the intermediate duct (168, 172) is at a distance (d) from the air discharge orifice (104) and/or from the air outlet means (166).

10. Premises (150) according to one of Claims 7 to 9, **characterized in that** the air inlet orifice (102) and the air inlet means (164) are placed so that the air that penetrates the air inlet means (164) traverses the majority of the volume of said premises (150).

11. Premises (150) according to one of Claims 7 to 10, **characterized in that** the portion (108a) of the pipe (108) containing the device (106) for carrying air along is placed inside said premises (150).

12. Premises (150) according to one of Claims 7 to 10, **characterized in that** the portion (108a) of the pipe (108) containing the device (106) for carrying air along is placed on the outside of said premises (150).

## Patentansprüche

1. Belüftungssystem (100) eines Raums, das dazu vorgesehen ist, an einem Träger (156) montiert zu werden, der eine Grundfläche (162) aufweist, wobei das Belüftungssystem (100) enthält:
- eine Luftzuführungsöffnung (102);
- eine Luftabführungsöffnung (104);
- eine dichte Leitungsanordnung (108), die die Luftzuführungsöffnung (102) mit der Luftabführungsöffnung (104) verbindet;
- eine Luftantriebsvorrichtung (106), die in einem Abschnitt (108a) der Leitungsanordnung (108) angeordnet ist,
wobei das Belüftungssystem (100) **dadurch gekennzeichnet ist, dass** die Luftzuführungsöffnung (102) dazu ausgelegt ist, Luft des zu belüftenden Raums einzufangen;
und dass dann, wenn das Belüftungssystem in der montierten Position ist, der genannte Abschnitt (108a) sich in Bezug auf die Grundfläche auf einer Höhe oberhalb jener der Luftzuführungsöffnung (102) und jener der Luftabführungsöffnung (104) befindet.

2. Belüftungssystem (100) nach Anspruch 1, **dadurch gekennzeichnet, dass** die Leitung (108) die Form eines U hat, wovon ein Schenkel (108b) mit der Luftzuführungsöffnung (102) über eine erste Verbindungsleitung (110) verbunden ist und wovon der andere Schenkel (108c) mit der Luftabführungsöffnung (104) durch eine zweite Verbindungsleitung (112) verbunden ist, und dass dann, wenn das Belüftungssystem (100) in der montierten Position ist, die erste Verbindungsleitung (110) und die zweite Verbindungsleitung (112) in Bezug auf die Grundfläche im Wesentlichen horizontal sind.

3. Belüftungssystem (100) nach einem der Ansprüche 1 bis 2, **dadurch gekennzeichnet, dass** dann, wenn das Belüftungssystem (100) in der montierten Position ist, die Luftzuführungsöffnung (102) und die Luftabführungsöffnung (104) sich in Bezug auf die Grundfläche im Wesentlichen auf derselben Höhe befinden.

4. Belüftungssystem (100) nach einem der Ansprüche 1 bis 3, **dadurch gekennzeichnet, dass** der Abschnitt (108a) auf Höhe der Luftantriebsvorrichtung (106) mit einer Kapillaritätsverhinderungsvorrichtung versehen ist.

5. Belüftungssystem (100) nach einem der Ansprüche 1 bis 4, **dadurch gekennzeichnet, dass** in der Leitung (108) wenigstens ein Thermostat (180) angeordnet ist.

6. Belüftungssystem (100) nach einem der Ansprüche 1 bis 5, **dadurch gekennzeichnet, dass** in der Leitung (108) wenigstens ein Detektor (206) für die Anwesenheit von Wasser angeordnet ist.

7. Raum (150), der enthält: - eine Anordnung von Wänden (152-162), wovon wenigstens eine eine Grundfläche (162) ist, - ein Lufteintrittsmittel (164), das an einer der Wände (152) angeordnet ist; - ein Luftaustrittsmittel (166), das an einer der Wände (152) angeordnet ist; wobei der Raum **dadurch gekennzeichnet ist, dass** er außerdem ein Belüftungssystem (100) nach einem der Ansprüche 1 bis 6 enthält, das an einer Wand (156), die als Träger dient, montiert ist, wobei die in dem Raum (150) enthaltene Luft durch die Luftzuführungsöffnung (102) eingefangen und dann von der Luftabführungsöffnung (104) zu dem Luftaustrittsmittel (166) geleitet wird.

8. Raum (150) nach Anspruch 7, **dadurch gekennzeichnet, dass** zwischen der Luftabführungsöffnung (104) und dem Luftaustrittsmittel (166) eine Zwischenleitung (168, 172) angeordnet ist.

9. Raum (150) nach Anspruch 8, **dadurch gekennzeichnet, dass** die Zwischenleitung (168, 172) von der Luftabführungsöffnung (104) und/oder von dem Luftaustrittsmittel (166) beabstandet (d) ist.

10. Raum (150) nach einem der Ansprüche 7 bis 9, **dadurch gekennzeichnet, dass** die Luftzuführungsöffnung (102) und das Lufteintrittsmittel (164) in der Weise angeordnet sind, dass Luft, die durch das Lufteintrittsmittel (164) eindringt, den größten Teil des Volumens des Raums (150) durchquert.

11. Raum (150) nach einem der Ansprüche 7 bis 10, **dadurch gekennzeichnet, dass** der Abschnitt (108a) der Leitung (108), der die Luftantriebsvorrichtung (106) enthält, innerhalb des Raums (150) angeordnet ist.

12. Raum (150) nach einem der Ansprüche 7 bis 10, **dadurch gekennzeichnet, dass** der Abschnitt (108a) der Leitung (108), der die Luftantriebsvorrichtung (106) enthält, außerhalb des Raums (150) angeordnet ist.
